# EUROPÄISCHE PATENTSCHRIFT

(11) **EP 3 738 144 B1**
(45) Veröffentlichungstag und Bekanntmachung des Hinweises auf die Patenterteilung: **30.07.2025**
(21) Anmeldenummer: 18833662.2
(22) Anmeldetag: 21.12.2018
(51) Int. Cl.: H01L 23/40

(54) **BEFESTIGUNGSEINHEIT ZUM MITEINANDERVERBINDEN THERMISCH BELASTETER BAUTEILE**
FASTENING UNIT FOR CONNECTING THERMALLY STRESSED COMPONENTS TO EACH OTHER
UNITÉ DE FIXATION POUR RELIER ENTRE EUX DES COMPOSANTS SOUMIS À DES CONTRAINTES THERMIQUES

(30) Priorität: 12.01.2018 DE 102018100647; 12.01.2018 DE 202018100161 U
(43) Veröffentlichungstag der Anmeldung: 18.11.2020
(73) Patentinhaber: Fachhochschule Kiel, 24149 Kiel (DE)
(72) Erfinder: SCHNACK, Jasper, 24149 Kiel (DE); SCHÜMANN, Ulf, 24149 Kiel (DE)
(74) Vertreter: Puschmann Borchert Kaiser Klettner Patentanwälte Partnerschaft mbB
(86) Internationale Anmeldenummer: PCT/EP2018/086658
(87) Internationale Veröffentlichungsnummer: WO 2019/137806

(56) Entgegenhaltungen:
- WO-A1-00/62340
- DE-U1- 202005 008 256
- JP-A- S6 024 041

## Beschreibung

Die Erfindung betrifft eine Befestigungseinheit zum Miteinanderverbinden thermisch belasteter Bauteile gemäß der im Oberbegriff des Patentanspruchs 1 angegebenen Art. Zudem betrifft die Erfindung auch die Verwendung dieser Befestigungseinheiten gemäß Patentanspruch 13.

Eine gattungsgemäße Befestigungseinheit zum Miteinanderverbinden thermisch belasteter Bauteile, insbesondere eines wärmeerzeugenden Körpers mit einem Kühlkörper, umfasst einen Haltestift und ein Halteelement. Der Haltestift ist mit einem Haltekopf verbunden. Der Haltestift durchgreift das Halteelement. Der Haltekopf liegt an dem Halteelement an. Das Halteelement greift an dem Körper oder Kühlkörper an und hält diesen in einer Befestigungsrichtung des Haltestifts. In der Befestigungsposition hält der mit dem Haltestift verbundene Haltekopf das Halteelement und dieses wiederum den Körper oder Kühlkörper. Der Befestigungsstift ist dabei in einer Bohrung eines Bauteils verankert, beispielsweise eines Kühlkörpers, wenn ein thermische Energie erzeugendes Leistungsmodul gehalten werden soll.

Aus der DE 103 06 227 A1 ist ein Leistungsmodul als thermisch belasteter Körper bekannt, welcher zumindest eine Platine und wärmeerzeugende Bauelemente umfasst. Zudem ist ein Kühlkörper vorgesehen, der als Hohlkörper ausgeführt ist und von einem Kühlmedium zur Wärmeabfuhr durchströmt wird. Die wärmeerzeugenden Bauelemente sind auf der Außenseite des Kühlkörpers auf Kühlflächen angeordnet und mit diesen wärmeleitend verbunden. Der Kühlkörper ist symmetrisch ausgebildet und mit mehreren, schräg angestellten, um eine Längsachse des Kühlkörpers herum angeordneten Kühlflächen versehen. In der zentrisch angeordneten Längsachse des Kühlkörpers ist eine Befestigungsschraube mit einem Schraubenkopf vorgesehen, welche über eine spinnenförmig ausgebildete Klemmfeder den Kühlkörper und die Platine miteinander verbindet. Die Klemmfeder drückt die wärmeerzeugenden Bauelemente auf die Kühlflächen des Kühlkörpers und dient gleichzeitig zur Wärmeableitung. Eine derartige Gestaltung ist sehr aufwendig, da für jede Kühlkörperform ein Halteelement in Form der spinnenförmigen Klemmfeder bereitgestellt werden muss.

Die DE 196 30 173 C2 offenbart ein Leistungsmodul mit Halbleiterbauelementen mit einer Platine, auf der mehrere chipförmige Leistungshalbleiterbauelemente und Kontaktflächen angeordnet sind. Auf der Platine ist ein Gehäuse mit Druckkontakten angeordnet, um die Platine entsprechend zu schalten. Über eine zentrisch angeordnete Befestigungsschraube wird ein Druckstück auf dem Gehäuse fixiert und die Leiterplatte mit den Druckstück fest verbunden. Das Druckstück ist aus einem elektrisch isolierenden Material gebildet. Um das Befestigungselement gegenüber dem Gehäuse der Platine zu isolieren ist eine Hülse im Gehäuse vorgesehen, welche die Befestigungsschraube umgibt. Problematisch bei dieser Ausbildung ist, dass die miteinander verbundenen Bauteile - Platine, Gehäuse, und Druckstück, welche aus unterschiedlichen Materialien bestehen und durch die im Betrieb entstehende Temperatur unterschiedlichen Ausdehnungen unterworfen sind, sich relativ zueinander nicht bewegen können. Es kommt zu Verspannungen und vorzeitigen Materialermüdungen.

Die WO 00/62340 A1 offenbart ein Verfahren zum Verbinden von zwei thermisch belasteten Bauteilen miteinander. Mit Hilfe einer Loslagerung werden die Bauteile miteinander verbunden, welche eine Relativbewegung des einen Bauteils und des anderen Bauteils zumindest entlang einer Achse ermöglicht.

Der Erfindung liegt die Aufgabe zugrunde, eine Befestigungseinheit gemäß der im Oberbegriff des Anspruches 1 angegebenen Art derart weiterzubilden, dass unter Vermeidung der genannten Nachteile ein Verspannen durch thermische Ausdehnung von thermisch belasteten Körpern und weiteren Körpern auf einfache Weise verhindert wird.

Diese Aufgabe wird durch die kennzeichnenden Merkmale von Anspruch 1in Verbindung mit seinen Oberbegriffsmerkmalen gelöst.

Die Unteransprüche bilden vorteilhafte Weiterbildungen der Erfindung.

Nach der Erfindung ist das Haltelement für einen seitlichen Angriff am Körper oder Kühlkörper ausgebildet, indem das Halteelement an seiner dem Körper oder Kühlkörper zugewandten Seite eine in eine Längsrichtung quer zur Befestigungsrichtung sich erstreckende Haltenut aufweist, wobei zumindest eine Nutfläche im montiertem Zustand zumindest bereichsweise an dem Körper oder Kühlkörper zur Anlage kommt. Hierdurch wird auf einfache Weise möglich, dass bei einer thermischen Ausdehnung des Kühlkörpers oder des Körpers eine Relativbewegung bei entsprechender Montage ermöglicht werden kann.

Gemäß einer vorteilhaften Weiterbildung der Erfindung ist die Haltenut V-förmig durch zwei Nutflächen gebildet, wobei eine Nutfläche parallel zur Längsachse des Befestigungsstifts und die andere Nutfläche geneigt dazu ausgerichtet ist, insbesondere die Nutflächen einen spitzen oder stumpfen Winkel zueinander aufweisen. Durch diese V-förmige Haltenut können unterschiedliche Randbereiche von Kühlkörpern einfach gehalten werden, ohne eine Bewegung längst der Haltenut einzuschränken. Je nach Gestaltung des Randbereichs des Körpers oder Kühlkörpers oder zu erwartender thermischer Spannung bietet sich ein spitzer oder stumpfer Winkel an. Es kommt zu einer linienförmigen oder flächigen Anlage zumindest einer Nutfläche der Haltenut an dem zu haltenden Körper oder Kühlkörper.

Vorzugsweise weist das Halteelement im Wesentlichen eine rechteckige Grundfläche auf. Hierdurch kann dieses einfach gefertigt, aber auch einfach bei der Montage zum zu haltenden Körper ausgerichtet werden. Insbesondere weist hierfür das Halteelement in Längsrichtung der Haltenut eine größere Länge auf als quer zur Längsrichtung der Haltenut.

Gemäß einer weiteren Ausführungsform der Erfindung ist das Halteelement symmetrisch ausgebildet und weist zwei Haltenuten auf, so dass das Halteelement an unterschiedlichen benachbart angeordneten Körpern oder Kühlkörpern gleichzeitig zur Anlage kommen kann. Hierdurch wird der Einsatzbereich vergrößert und die Flexibilität der Befestigungseinheit erhöht.

Um insbesondere das Halteelement vor Rotation gegenüber dem zu haltenden Körper oder Kühlkörper zu schützen, hat es sich als günstig erwiesen, dass das Halteelement mittig, seitlich des Befestigungsstiftes jeweils einen länglichen, senkrecht zum Stift verlaufenden Vorsprung aufweist, der seinerseits auf der dem Haltekopf entfernt gelegenen Seite eine weitere Nut aufweist. Diese Nut greift insbesondere an eine Leiste an. Es ergibt sich dadurch ein Formschluss in Drehrichtung, der jedoch eine Bewegung relativ zur Haltenut durch thermische Ausdehnung nicht beeinträchtigt. Ein Verdrehen des Halteelements wird somit verhindert, jedoch eine thermische Ausdehnung in Längsrichtung der Nut sowie der parallel hierzu angeordneten Haltenut bleibt weiterhin erhalten.

Vorzugsweise ist auch die weitere Nut V-förmig ausgebildet. Auf einfache Weise kann hierdurch sowohl eine Linienführung als auch eine flächige Anlage ermöglicht werden, je nach Ausbildung der der Nut gegenüberliegenden Anlagefläche des zu haltenden Körpers bzw. Kühlkörpers.

Damit die Befestigungseinheit nicht so hoch baut, greift der Haltekopf in eine Ausnehmung des Halteelements ein und liegt dort an.

Insbesondere sind der Haltekopf und die Ausnehmung des Halteelements zylindrisch ausgebildet, so dass eine Stirnseite des Haltekopfs auf der Stirnseite der Ausnehmung anliegt und eine relative Ausgleichsbewegung um die Zylinderachse ermöglicht wird. Dies ist bei der Montage zum Ausrichten des Haltelements zum zu haltenden Körper oder Kühlkörper vorteilhaft. Zudem kann dies bei bestimmten Konstruktionen der Körper und Kühlkörper auch zum Ausgleich von Spannungen günstig sein.

Alternativ hierzu ist es aber auch möglich, dass der Haltekopf auf seiner der Ausnehmung zugewandten Seite zumindest teilkugelförmig ausgebildet ist, die Ausnehmung eine dem Haltekopf angepasste Teilkugelform aufweist, so dass die einander zugewandten kugelförmigen Flächen eine Ausgleichsbewegung relativ zueinander in der Art eines Kugelgelenks ermöglichen. Hierdurch wird erreicht, dass es durch die thermische Ausdehnung des miteinander verbundenen Körpers und Kühlkörpers nicht zu Verspannungen infolge von Drehmomenten kommt.

Der Stift kann an seinem dem Haltekopf entfernt gelegenen Ende ein Gewinde aufweisen, das einem Gewinde in einer Bohrung im Kühlkörper oder Körper zugeordnet ist. Hierdurch wird die Befestigungseinheit und somit der Körper und der Kühlkörper über die Befestigungseinheit miteinander verschraubt.

Alternativ hierzu kann der Stift an seinem dem Haltekopf entfernt gelegenen Ende zumindest ein Rastmittel aufweisen, das einem Hinterschnitt in einer Bohrung im Kühlkörper oder Körper zugeordnet ist. Der Stift ist dabei im Bereich des dem Haltekopf entfernt gelegenen Endes geschlitzt ausgebildet. Durch eine Rastverbindung können der Körper und der Kühlkörper über die Befestigungseinheit miteinander verbunden werden. Die Montage wird dadurch vereinfacht.

Vorzugsweise wird der Körper durch einen Leistungshalbleiter gebildet. Leistungshalbleiter erzeugen viel Wärme und müssen durch Kühlkörper gekühlt werden. Die erfindungsgemäßen Befestigungseinheiten sind hierfür besonders geeignet, da die Kühlkörper Ausdehnungen unterworfen sind.

Der Kühlkörper kann dabei ein Luftkühlkörper und/oder ein Flüssigkeitskühlkörper sein.

Nach einer Ausführungsform der Erfindung besteht der Haltekopf der Befestigungseinheit aus einem thermisch und/oder elektrisch isolierenden Material, oder aus einem elektrisch leitenden Material.

Gemäß einem anderen Aspekt zeichnet sich die Erfindung durch die Verwendung zumindest zweier Befestigungseinheiten gemäß der oben angegebenen Art zum Verbinden eines Kühlkörpers und eines Körpers miteinander aus, wobei zwei Befestigungseinheiten diametral gegenüber liegend am Körper oder Kühlkörper angebracht werden, und mit dem Körper oder Kühlkörper eine Loslagerung bilden. Hierdurch wird auf einfache Weise möglich, dass eine Relativbewegung zwischen Körper und Kühlkörper entlang der Haltenuten der Halteelemente der Befestigungseinheiten erfolgen kann.

Hierbei sind im montierten Zustand die Haltenuten der Befestigungseinheiten vor allem zueinander parallel ausgerichtet.

Weitere Vorteile, Merkmale und Anwendungsmöglichkeiten der vorliegenden Erfindung ergeben sich aus der nachfolgenden Beschreibung in Verbindung mit den in den Zeichnungen dargestellten Ausführungsbeispielen.

In der Beschreibung, in den Ansprüchen und in der Zeichnung werden die in der unten aufgeführten Liste der Bezugszeichen verwendeten Begriffe und zugeordneten Bezugszeichen verwendet. In der Zeichnung bedeutet:
- Fig. 1a: eine schematische Seitenansicht einer Befestigungseinheit gemäß einer ersten Ausführungsform der Erfindung;
- Fig. 1b: eine perspektivische Ansicht von schräg oben auf die Befestigungseinheit von Figur 1a;
- Fig. 1c: eine Explosionsdarstellung von Fig. 1b;
- Fig. 2a: eine schematische Seitenansicht einer Befestigungseinheit gemäß einer zweiten Ausführungsform der Erfindung;
- Fig. 2b: eine perspektivische Ansicht von schräg oben auf die Befestigungseinheit von Figur 2a;
- Fig. 2c: eine Explosionsdarstellung von Fig. 2b;
- Fig. 3a: eine schematische Seitenansicht einer Befestigungseinheit gemäß einer dritten Ausführungsform der Erfindung;
- Fig. 3b: eine perspektivische Ansicht von schräg oben auf die Befestigungseinheit von Figur 3a;
- Fig. 4a: eine schematische Seitenansicht einer Befestigungseinheit gemäß einer vierten Ausführungsform der Erfindung;
- Fig. 4b: eine perspektivische Ansicht von schräg oben auf die Befestigungseinheit von Figur 4a;
- Fig. 5: ein erstes Anwendungsbeispiel in einer Schnittansicht der dritten Ausführungsform der Erfindung im montierten Zustand;
- Fig. 6: ein zweites Anwendungsbeispiel in einer Schnittdarstellung der dritten Ausführungsform der Erfindung im montierten Zustand, und
- Fig. 7: ein drittes Anwendungsbeispiel in einer perspektivischen Explosionsdarstellung der ersten Ausführungsform der Erfindung im montierten Zustand.

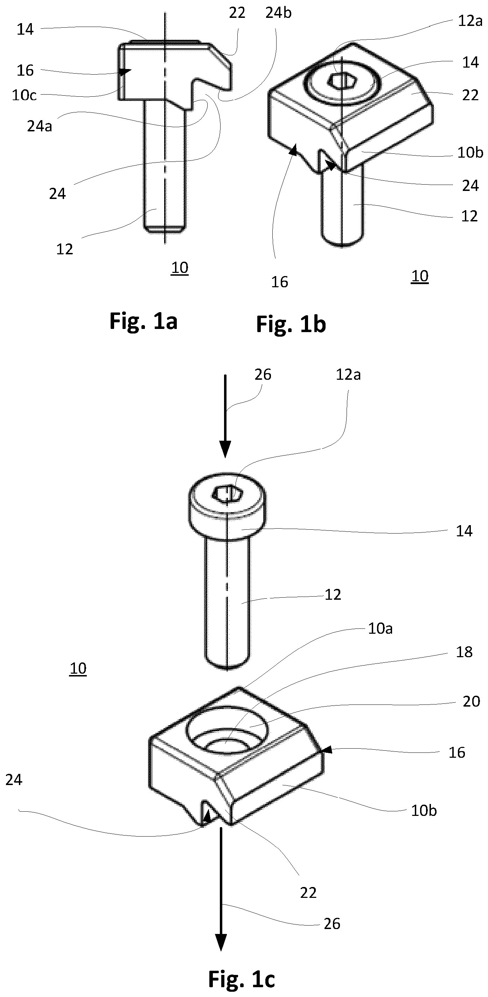

In den Fig. 1a, 1b und 1c ist eine erste Ausführungsform einer Befestigungseinheit 10 dargestellt. Die Befestigungseinheit 10 umfasst einen Befestigungsstift 12, der mit einem Haltekopf 14 materialeinheitlich fest verbunden ist. Im vorliegenden Fall ist der Befestigungsstift 12 mit dem Haltekopf 14 aus einem Stück gefertigt. Der Haltekopf 14 ist zylindrisch ausgeführt und weist einen Innensechskant 12a zum Eindrehen des Befestigungsstiftes 12 bei der Montage auf. Der Innensechskant 12a bildet einen Innenantrieb für den Befestigungsstift 12.

Zudem umfasst die Befestigungseinheit 10 ein Halteelement 16, welches eine Durchgangsbohrung 18 sowie konzentrisch hierzu eine zylindrische Ausnehmung 20 auf der nach oben weisenden Seite 10a aufweist. Das Halteelement 16 weist in der Draufsicht eine rechteckige Grundform auf. In Längsrichtung ist das Halteelement 16 länger ausgebildet als in Querrichtung. Auf einer ersten Längsseite 10b kragt ein Haltearm 22 über die gesamte Längsseite 10b aus und ist gegenüber der nach oben weisenden Seite 10a schräg angestellt. Unterhalb des Haltearms 22 ist eine V-förmige Haltenut 24 parallel zur Längsseite 10a vorgesehen, wobei die Durchgangsbohrung 18 nächstgelegene Nutfläche 24a parallel zur Durchgangsbohrung 18 verläuft und die weitere Nutfläche 24b hierzu schräg angestellt ist.

Wie insbesondere der Fig. 1a zu entnehmen ist, bilden die Nutflächen 24a und 24b der Haltenut 24 einen spitzen Winkel zueinander.

Die Nutfläche 24a ist nach unten verlängert und die Unterseite des Halteelements 16 fällt bereichsweise schräg zur Nutfläche 24a ab.

Der Befestigungsstift 12 mit Haltekopf 14 wird in Befestigungsrichtung, welche mit dem Bezugszeichen 26 bezeichnet ist, in die Durchgangsbohrung 18 gesteckt, bis der Haltekopf 14 mit seiner Stirnseite auf der nach oben weisenden Fläche der Ausnehmung 20 zur Anlage kommt. In diesem Zustand schließt die obere Stirnseite des Haltekopfs 14 mit der nach oben weisenden Seite 10a in einer Höhe ab.

Mit dem Einbringen des Befestigungsstifts 12 mit Haltekopf 14 in die Durchgangsbohrung 18 und die Ausnehmung 20 des Halteelements 16 wird der Befestigungsstift 12 auch in einem Kühlkörper oder einem anderen Bauteil verankert, wie dies weiter unten im Einzelnen noch ausgeführt wird.

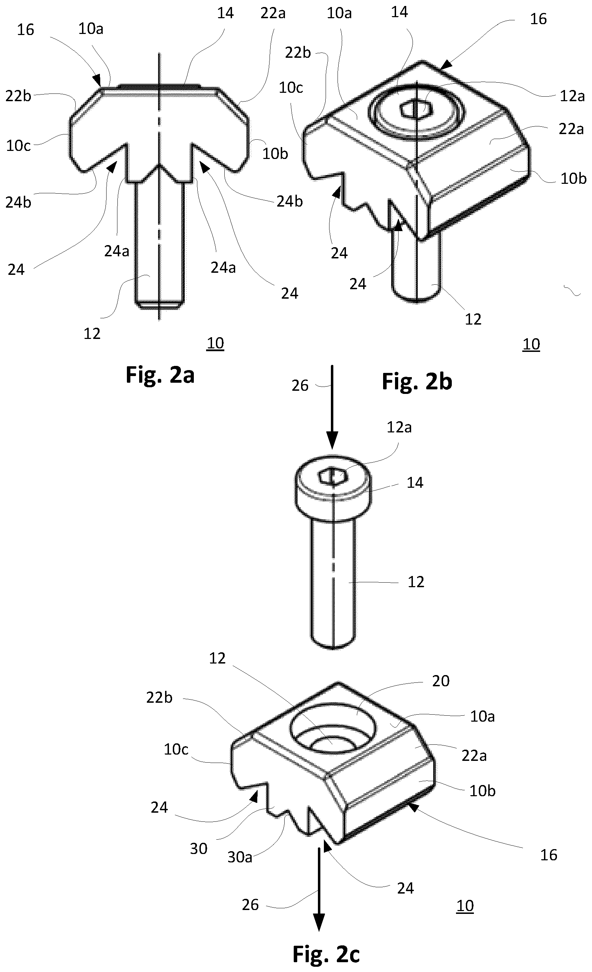

In den Fig. 2a, 2b und 2c ist eine zweite Ausführungsform der Erfindung dargestellt. Wie die in den Figuren 1a, Fig. 1b und Fig. 1c dargestellte Befestigungseinheit 10 weist auch diese den Befestigungsstift 12 mit Haltekopf 14 auf. Lediglich das Halteelement 16 ist insoweit unterschiedlich ausgebildet, dass auf beiden Längsseiten10b und 10c ein Haltearm 22a, 22b über die gesamte Längsseite 10b bzw. 10c seitlich auskragt, unter jedem Haltearm 22a, 22b jeweils eine Haltenut 24c, 24d vorgesehen ist und die parallel zu Durchgangsbohrung 18 verlaufende Nutfläche 24a nach unten verlängert ist. Hierdurch ergibt sich ein seitlich zum Befestigungsstift 12 verlaufender Steg mit einer mittigen Nut 30. Das Halteelement 16 ist symmetrisch ausgebildet mit zwei Haltenuten 24c und 24d und einer mittig verlaufenden weiteren Nut 30. Die Nut 30, der Steg 30a sowie die Haltenuten 24c und 24d verlaufen zueinander parallel und senkrecht zur Längsachse und Befestigungsrichtung 26 der Befestigungseinheit 10.

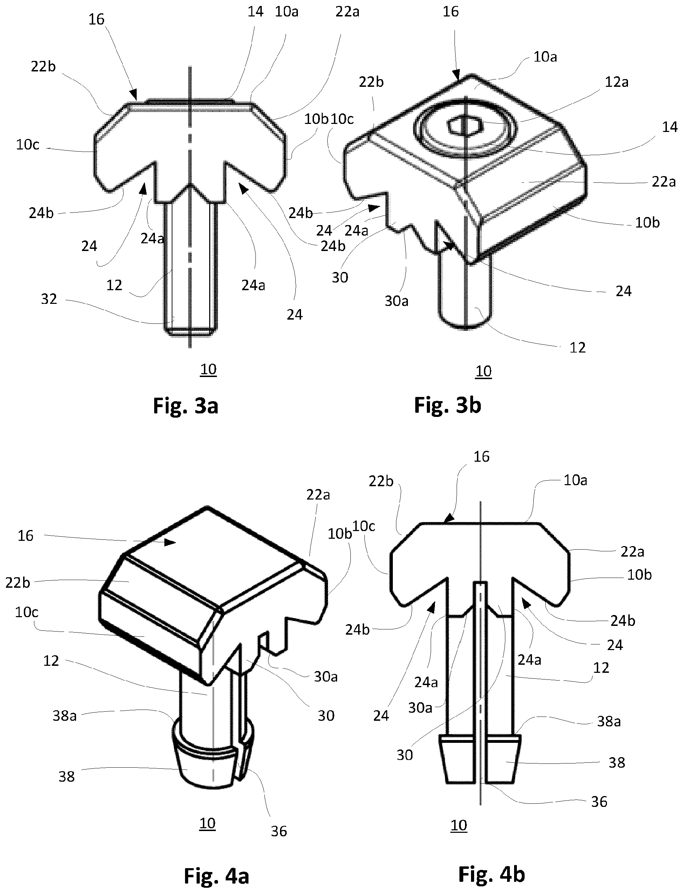

In den Fig. 3a und 3b ist eine dritte Ausführungsform der Erfindung dargestellt, welche im Wesentlichen der zweiten Ausführungsform entspricht, wobei der Befestigungsstift 12 ein Gewinde 32 aufweist, welches einem hier nicht dargestellten Gewinde in einem ebenfalls hier nicht dargestellten Kühlkörper zugeordnet ist. Der Befestigungsstift 12 ist somit zum Einschrauben in ein zugeordnetes Gewinde ausgebildet.

In den Fig. 4a und 4b ist eine vierte Ausführungsform der Erfindung dargestellt, welche im Wesentlichen der zweiten Ausführungsform entspricht, wobei der Befestigungsstift 12 einen von seinem freien Ende 34 bis in das Halteelement 16 hinein verlaufenden Schlitz 36 aufweist. Zudem sind der Befestigungsstift 12 und das Halteelement 16 einstückig ausgebildet und aus einem Stück gefertigt. Am freien Ende 34 ist eine Raste 38 vorgesehen, welche einen Absatz 38a bildet und zum freien Ende 34 hin sich verkleinert. Der Befestigungsstift 12 sowie die Raste 38 sind im Wesentlichen zylindrisch bzw. kegelförmig ausgebildet. In einer hier nicht dargestellten Bohrung in einem ebenfalls hier nicht dargestellten Kühlkörper ist ein Hinterschnitt eingebracht, in dem die Raste 38 im montierten Zustand eingreift und der Absatz 38a am Hinterschnitt zur Anlage kommt. Über die Raste 38 wird die Befestigungseinheit 10 in der Bohrung befestigt.

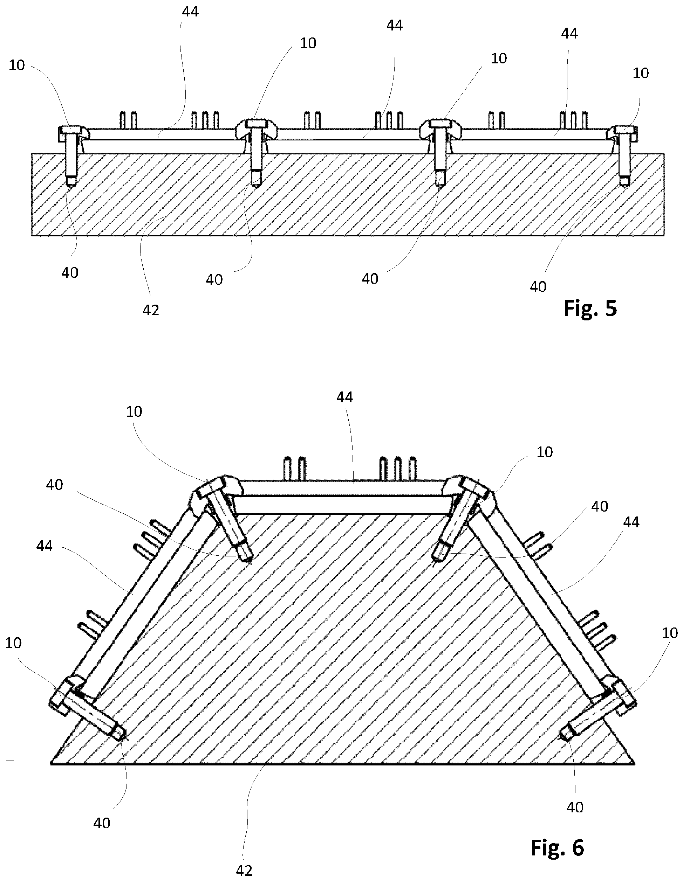

In den Fig. 5 bis 7 sind unterschiedliche Ausführungsbeispiele von Anwendungen der erfindungsgemäßen Befestigungseinheiten 10 gezeigt.

Die Fig. 5 und 6 zeigen jeweils Befestigungseinheiten 10 gemäß der ersten und dritten Ausführungsform mit einem ein Gewinde 32 aufweisenden Befestigungsstift und sind jeweils in eine Gewindebohrung 40 eines Kühlkörpers 42 eingeschraubt.

In Fig. 5 ist der Kühlkörper 42 im Wesentlichen quaderförmig ausgebildet. An der Oberseite sind thermische Energie erzeugende Leistungshalbleiter 44 über die Befestigungseinheiten 10 mit dem Kühlkörper verbunden, sodass die Haltearme 22 mit den Haltenuten 24 der Befestigungseinheiten jeweils an dem Rand des Leistungshalbleiters 44 zur Anlage kommen. An den äußeren Seiten des Kühlkörpers sind Befestigungseinheiten 10 gemäß der ersten Ausführungsform vorgesehen, welche lediglich an einem Rand eines Leistungshalbleiters 44 angreifen und diesen halten, wobei im mittleren Bereich Befestigungseinheiten 10 gemäß der dritten Ausführungsform vorgesehen sind, welche mit ihren Haltearmen 22a, 22b und den Haltenuten 24c, 24d an den Rändern zweier unterschiedlicher Leistungshalbleiter 44 angreifen und diese halten. Die Haltearme 22a, 22b mit ihren Haltenuten 24c, 24d liegen jeweils linienförmig oder flächig am Rand des Leistungshalbleiters 44 an. Alle Haltenuten 24 der Befestigungseinheiten 10 sind parallel zueinander ausgerichtet.

In Fig. 6 ist ein im Schnitt trapezförmiger Kühlkörper dargestellt. Auch hier sind die Leistungshalbleiter 44 an der Oberseite des Kühlkörpers 42 angeordnet. An der äußeren Seite des Kühlkörpers 42 sind Befestigungseinheiten 10 gemäß der ersten Ausführungsform in den Kühlkörper 42 eingeschraubt und halten am Rand einen Leistungshalbleiter 44. In mittleren Bereich sind Befestigungseinheiten 10 nach der dritten Ausführungsform an den Kanten des Kühlkörpers 42 in eine entsprechende Bohrung eingeschraubt, greifen an jeweils zwei benachbarte Leistungshalbleiter 44 an und halten diese. Hieraus wird deutlich, dass durch die V-förmigen Haltenuten 24 auch zueinander schräg angestellte Leistungshalbleiter 44 auf einfache Weise fixiert werden können, ohne dass die Halteelemente 16 angepasst werden müssen.

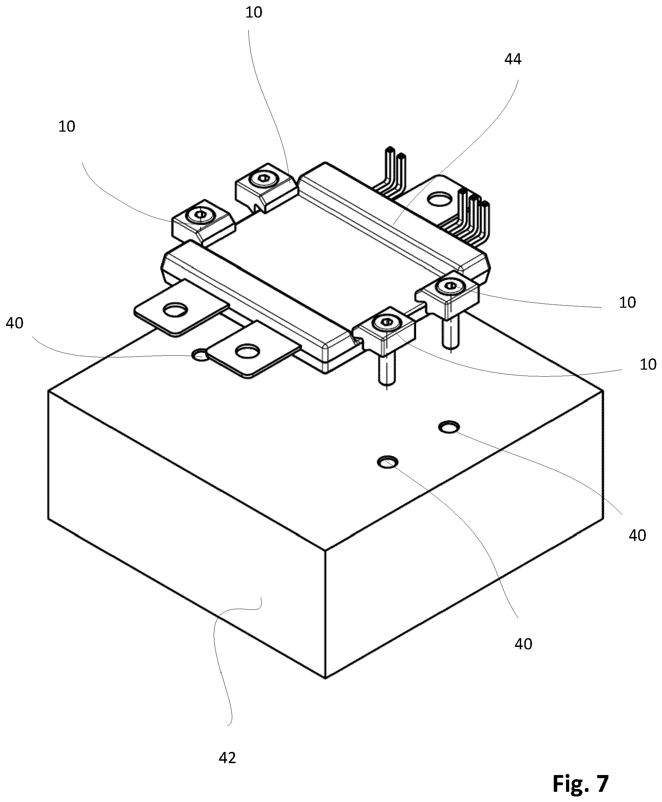

In Fig. 7 wird die Anordnung der Befestigungseinheiten 10 im Kühlkörper 42 und relativ zum Rand des Leistungshalbleiters veranschaulicht. Die Befestigungsstifte 12 werden in zugeordnete Bohrungen 40 im Kühlkörper 42 eingeschraubt. Es handelt sich hierbei um Befestigungseinheiten 10 gemäß der ersten Ausführungsform.

Durch die Haltenuten 24 und die Befestigung der Befestigungseinheiten 10 an gegenüberliegenden Seiten wird es ermöglicht, dass eine Ausdehnung der Leistungshalbleiter 44 parallel zu den Haltenuten 24 erfolgen kann. Ein Verspannen wird vermieden. Beispielsweise sind jeweils zwei Befestigungseinheiten 10 auf jeder Längsseite eines Leistungshalbleiters 44 angeordnet. Je nachdem, ob die Befestigungseinheiten 10 ein oder zwei benachbarte Leistungshalbleiter 44 halten sollen, kommt die Ausführungsform der Befestigungseinheit 10 mit einem Haltearm 22 oder zwei Haltearmen 22a, 22b zum Einsatz. Die Leistungshalbleiter 44 werden somit durch eine Loslagerung gehalten, d.h. eine Bewegung in eine Richtung wird ermöglicht. Diese Richtung ist die Hauptausdehnungsrichtung des Leistungshalbleiters 44.

Über die Länge der seitlichen Auskragung der Haltearme 22 kann der Abstand zweier Leistungshalbleiter 44 zueinander aber auch der Abstand der Bohrung für den Befestigungsstift 12 zum Rand des Leistungshalbleiters 44 eingestellt werden.

Vorzugsweise ist ein Satz Halteelemente 16 vorgesehen, welche unterschiedliche Längen der seitlichen Auskragung der Haltearme 22 aufweisen. Je nach Bedarf wird dann das Halteelement 16 mit einem größeren seitlich auskragenden oder einem geringer seitlich auskragenden Haltearm 22 genommen. Der Befestigungsstift 12 mit Haltekopf 14 kann für die unterschiedlichen Halteelemente 16 gleich bleiben. Es können aber auch unterschiedliche Längen und Durchmesser aufweisende Befestigungsstifte 12 bei der Montage bereitgestellt werden.

Je nach Anwendungsfall können die Befestigungseinheiten 10 elektrisch leitend, elektrisch isolierend, thermisch leitend oder thermisch isoliert ausgebildet sein. Möglich ist auch, dass die Halteelemente 16 auf der einen Seite und der Befestigungsstift 12 mit Haltekopf 14 auf der anderen Seite unterschiedliche Materialeigenschaften haben.

Die Befestigungseinheiten 10 nach der Erfindung ermöglichen somit auf einfache Weise die Ausdehnung der Leistungshalbleiter 44 und somit eine Relativbewegung zwischen Leistungshalbleiter 44 und Kühlkörper 42. Durch die feste Verankerung der Befestigungsstifte 12 wird eine elastische Verformung entlang der Befestigungsachse verhindert. Auf einfache Weise werden Verspannungen im Betrieb verhindert.

### Bezugszeichenliste

- 10: Befestigungseinheit
- 10a: nach oben weisende Seite
- 10b: Längsseite - rechts
- 10c: Längsseite - links
- 12: Befestigungsstift
- 12a: Innensechskant, Innenantrieb
- 14: Haltekopf
- 16: Halteelement
- 18: Durchgangsbohrung
- 20: Ausnehmung
- 22: Haltearm
- 22a: Haltearm - links
- 22b: Haltearm - rechts
- 24: Haltenut
- 24a: Nutfläche parallel zur Durchgangsbohrung 18
- 24b: Nutfläche schräg zur Durchgangsbohrung 18
- 24c: Haltenut - links
- 24d: Haltenut - rechts
- 26: Befestigungsrichtung
- 28: Steg
- 30: weitere Nut
- 30a: Steg
- 32: Gewinde
- 34: freies Ende
- 36: Schlitz
- 38: Raste
- 40: Bohrung
- 42: Kühlkörper
- 44: Leistungshalbleiter

## Patentansprüche

1. Befestigungseinheit (10) zum miteinander Verbinden thermisch belasteter Bauteile, insbesondere eines wärmeerzeugenden Körpers (44) mit einem Kühlkörper (42), umfassend einen Haltestift (12) und ein Halteelement (16), wobei der Haltestift (12) mit einem Haltekopf (14) verbunden ist, der Haltestift (12) das Haltelement (16) durchgreift, der Haltekopf (14) an dem Halteelement (16) anliegt, und das Haltelement (16) an dem Körper (44) oder Kühlkörper (42) angreift und diesen in einer Befestigungsrichtung (26) des Haltestifts (12) hält, wobei das Haltelement (16) für einen seitlichen Angriff am Körper (44) oder Kühlkörper (42) ausgebildet ist, indem das Halteelement (16) an seiner dem Körper (44) oder Kühlkörper (42) zugewandten Seite eine in eine Längsrichtung quer zur Befestigungsrichtung sich erstreckende Haltenut (24) aufweist, wobei zumindest eine Nutfläche (24a, 24b) im montierten Zustand zumindest bereichsweise an dem Körper (44) oder Kühlkörper (42) zur Anlage kommen, **dadurch gekennzeichnet, dass** das Haltelement (16) mittig, seitlich des Befestigungsstiftes (12) jeweils einen länglichen, senkrecht zum Befestigungsstift (12) verlaufenden Vorsprung (Steg 30a) aufweist, der seinerseits auf der dem Haltekopf (14) entfernt gelegenen Seite eine weitere Nut (30) aufweist.

2. Befestigungseinheit nach Anspruch 1, **dadurch gekennzeichnet, dass** die Haltenut (24) V-förmig durch zwei Nutflächen (24a, 24b) gebildet ist, wobei eine Nutfläche (24a; 24b) parallel zur Längsachse des Befestigungsstifts (12) und die andere Nutfläche (24a; 24b) geneigt dazu ausgerichtet ist, insbesondere die Nutflächen (24a, 24b) zueinander einen spitzen oder stumpfen Winkel aufweisen.

3. Befestigungseinheit nach Anspruch 1 oder 2, **dadurch gekennzeichnet, dass** das Halteelement (16) im Wesentlichen eine rechteckige Grundfläche aufweist.

4. Befestigungseinheit nach einem der vorangehenden Ansprüche, **dadurch gekennzeichnet, dass** das Halteelement (16) in Längsrichtung der Haltenut (24) eine größere Länge aufweist als quer zur Längsrichtung der Haltenut (24).

5. Befestigungseinheit nach einem der vorangehenden Ansprüche, **gekennzeichnet durch** eine symmetrische Ausbildung des Halteelements (16) mit zwei Haltenuten (24), so dass das Halteelement (16) an unter schiedlichen benachbart angeordneten Körpern (44) oder Kühlkörpern (42) gleichzeitig zur Anlage kommen kann.

6. Befestigungseinheit nach einem der vorangehenden Ansprüche, **dadurch gekennzeichnet, dass** die weitere Nut (30) V-förmig ausgebildet ist.

7. Befestigungseinheit nach einem der vorangehenden Ansprüche, **dadurch gekennzeichnet, dass** der Haltekopf (14) in eine Ausnehmung (20) des Halteelements (16) eingreift und dort anliegt.

8. Befestigungseinheit nach Anspruch 7, **dadurch gekennzeichnet, dass** der Haltekopf (14) zylindrisch und die Ausnehmung (20) zylindrisch ausgebildet ist, so dass eine Stirnseite des Haltekopfs (14) auf der Stirnseite der Ausnehmung (20) anliegt und eine relative Ausgleichsbewegung um die Zylinderachse ermöglicht wird.

9. Befestigungseinheit nach einem der Ansprüche 1 bis 8, **dadurch gekennzeichnet, dass** der Haltekopf (14) auf seiner der Ausnehmung (20) zugewandten Seite zumindest teilkugelförmig ausgebildet ist, die Ausnehmung (20) eine dem Haltekopf (14) angepasste Teilkugelform aufweist, so dass die einander zugewandten kugelförmigen Flächen eine Ausgleichsbewegung relativ zueinander in der Art eines Kugelgelenks ermöglichen.

10. Befestigungseinheit nach einem der vorangehenden Ansprüche, **dadurch gekennzeichnet, dass** der Befestigungsstift (12) an seinem dem Haltekopf (14) entfernt gelegenen Ende (34) ein Gewinde (32) aufweist, das einem Gewinde (32) in einer Bohrung (40) im Kühlkörper (42) oder Körper (44) zugeordnet ist.

11. Befestigungseinheit nach einem der vorangehenden Ansprüche, **dadurch gekennzeichnet, dass** der Befestigungsstift (12) an seinem dem Haltekopf (14) entfernt gelegenen Ende (34) ein Gewinde (32) aufweist, das einem Gewinde (32) in einer Bohrung (40) im Kühlkörper (42) oder Körper (44) zugeordnet ist.

12. Befestigungseinheit nach einem der vorangehenden Ansprüche, **dadurch gekennzeichnet, dass** der Haltekopf (14) aus einem thermisch und/oder elektrisch isolierenden Material, oder aus einem elektrisch leitenden Material besteht.

13. Verwendung zumindest zweier Befestigungseinheiten nach einem der vorangehenden Ansprüche zum Verbinden eines Kühlkörpers (42) und eines Körpers (44) miteinander, **dadurch gekennzeichnet, dass** zwei Befestigungseinheiten (10) gegenüberliegend am Rand des Körpers (44) oder Kühlkörpers (42) angebracht werden, und mit dem Körper (44) oder Kühlkörper (42) eine Loslagerung bilden.

14. Verwendung nach Anspruch 13, **dadurch gekennzeichnet, dass** im montierten Zustand die Haltenuten (24) der Befestigungseinheiten (10) zueinander parallel ausgerichtet sind.

## Claims

1. Fastening unit (10) for connecting thermally stressed components to each another, in particular a heat-generating body (44) to a heat sink (42), comprising a holding pin (12) and a holding element (16), wherein the holding pin (12) is connected to a holding head (14), the holding pin (12) engages through the holding element (16), the holding head (14) bears against the holding element (16), and the holding element (16) engages on the body (44) or the heat sink (42) and holds the latter in a fastening direction (26) of the holding pin (12), with the holding element (16) being designed for lateral engagement on the body (44) or the heat sink (42) for which purpose the holding element (16) has, on its side facing the body (44) or the heat sink (42), a holding groove (24) that extends in a longitudinal direction transverse to the fastening direction, with at least one groove surface (24a, 24b), in the assembled state, coming to rest against the body (44) or the heat sink (42), at least in some areas, **characterized in that,** in its center, on the side of the fastening pin (12), the holding element (16) has an elongate projection (web 30a) each, which extends perpendicularly to the fastening pin (12) and which in turn has an additional groove (30) on the side remote from the holding head (14).

2. Fastening unit according to claim 1, **characterized in that** the holding groove (24) is V-shaped, formed by two groove surfaces (24a, 24b), of which one groove surface (24a; 24b) extends in parallel to the longitudinal axis of the fastening pin (12) and the other groove surface (24a; 24b) is inclined thereto, which groove surfaces (24a, 24b) are in particular at an acute or obtuse angle to each another.

3. Fastening unit according to any one of claims 1 or 2 above, **characterized in that** the holding element (16) has a substantially rectangular base.

4. Fastening unit according to any one of the preceding claims, **characterized in that** the length of the holding element (16) is longer in the longitudinal direction of the holding groove (24) than transversely to the longitudinal direction of the holding groove (24).

5. Fastening unit according to any one of the preceding claims, **characterized by** a symmetrical design of the holding element (16) with two holding grooves (24), so as to enable the holding element (16) to come to rest against different adjacent bodies (44) or heat sinks (42) at the same time.

6. Fastening unit according to any one of the preceding claims, **characterized in that** the additional groove (30) is V-shaped.

7. Fastening unit according to any one of the preceding claims, **characterized in that** the holding head (14) engages in a recess (20) of the holding element (16) and makes contact there.

8. Fastening unit according to claim 7, **characterized in that** the holding head (14) is cylindrical and the recess (20) is cylindrical, resulting in one end face of the holding head (14) resting on the end face of the recess (20), which allows for a relative compensatory movement about the cylinder axis.

9. Fastening unit according to any one of claims 1 to 8 above, **characterized in that** the holding head (14) is at least partially spherical in shape on its side facing the recess (20), the recess (20) has a partial spherical shape adapted to the holding head (14), which allows for a compensatory movement of the spherical surfaces facing each another relative to one another in the manner of a ball-and-socket joint.

10. Fastening unit according to any one of the preceding claims, **characterized in that** the fastening pin (12) has, at its end (34) remote from the holding head (14), a thread (32) which is associated with a thread (32) in a bore (40) in the heat sink (42) or the body (44).

11. Fastening unit according to any one of the preceding claims, **characterized in that** the fastening pin (12) has, at its end (34) remote from the holding head (14), a thread (32) which is associated with a thread (32) in a bore (40) in the heat sink (42) or the body (44).

12. Fastening unit according to any one of the preceding claims, **characterized in that** the holding head (14) is made of a thermally and/or electrically insulating material, or of an electrically conductive material.

13. Use of at least two fastening units of the type claimed in any one of the preceding claims for connecting a heat sink (42) and a body (44) together, **characterized in that** two fastening units (10) are attached opposite one another on the edge of the body (44) or the heat sink (42) and thus form a loose bearing arrangement with the body (44) or the heat sink (42).

14. Use according to claim 13, **characterized in that,** in the assembled state, the holding grooves (24) of the fastening units (10) are aligned parallel to each another.

## Revendications

1. Unité de fixation (10) pour relier entre elles des pièces sollicitées thermiquement, en particulier un corps (44) générateur de chaleur avec un corps de refroidissement (42), comprenant une tige de retenue (12) et un élément de retenue (16), dans laquelle la tige de retenue (12) est reliée à une tête de retenue (14), la tige de retenue (12) traverse l'élément de retenue (16), la tête de retenue (14) s'applique sur l'élément de retenue (16), et l'élément de retenue (16) agit sur le corps (44) ou corps de refroidissement (42) et retient celui-ci dans une direction de fixation (26) de la tige de retenue (12), dans laquelle l'élément de retenue (16) est réalisé pour une action latérale sur le corps (44) ou corps de refroidissement (42), du fait que l'élément de retenue (16) présente sur sa face tournée vers le corps (44) ou corps de refroidissement (42) une rainure de retenue (24) s'étendant dans une direction longitudinale transversalement par rapport à la direction de fixation, dans laquelle au moins une surface de rainure (24a, 24b) dans l'état monté vient en appui au moins par endroits sur le corps (44) ou corps de refroidissement (42), **caractérisée en ce que** l'élément de retenue (16) présente de manière centrale, à côté de la tige de fixation (12), respectivement une saillie (nervure 30a) longitudinale, s'étendant perpendiculairement à la tige de fixation (12), qui présente de son côté sur la face éloignée de la tête de retenue (14) une autre rainure (30).

2. Unité de fixation selon la revendication 1, **caractérisée en ce que** la rainure de retenue (24) est formée en forme de V par deux surfaces de rainure (24a, 24b), dans laquelle une surface de rainure (24a ; 24b) est orientée parallèlement à l'axe longitudinal de la tige de fixation (12) et l'autre surface de rainure (24a ; 24b) inclinée par rapport à celle-ci, en particulier les surfaces de rainure (24a, 24b) présentent l'une par rapport à l'autre un angle aigu ou obtus.

3. Unité de fixation selon la revendication 1 ou 2, **caractérisée en ce que** l'élément de retenue (16) présente sensiblement une surface de base rectangulaire.

4. Unité de fixation selon l'une quelconque des revendications précédentes, **caractérisée en ce que** l'élément de retenue (16) présente dans la direction longitudinale de la rainure de retenue (24) une longueur plus grande que transversalement par rapport à la direction longitudinale de la rainure de retenue (24).

5. Unité de fixation selon l'une quelconque des revendications précédentes, **caractérisée par** une réalisation symétrique de l'élément de retenue (16) avec deux rainures de retenue (24), de sorte que l'élément de retenue (16) peut venir en appui simultanément sur différents corps (44) ou corps de refroidissement (42) disposés de manière adjacente.

6. Unité de fixation selon l'une quelconque des revendications précédentes, **caractérisée en ce que** l'autre rainure (30) est réalisée en forme de V.

7. Unité de fixation selon l'une quelconque des revendications précédentes, **caractérisée en ce que** la tête de retenue (14) s'insère dans un évidement (20) de l'élément de retenue (16) et s'y applique.

8. Unité de fixation selon la revendication 7, **caractérisée en ce que** la tête de retenue (14) est réalisée de manière cylindrique et l'évidement (20) de manière cylindrique, de sorte qu'une face avant de la tête de retenue (14) s'applique sur la face avant de l'évidement (20) et un mouvement de compensation relatif autour de l'axe de cylindre est permis.

9. Unité de fixation selon l'une quelconque des revendications 1 à 8, **caractérisée en ce que** la tête de retenue (14) est réalisée sur sa face tournée vers l'évidement (20) au moins en forme de sphère partielle, l'évidement (20) présente une forme de sphère partielle adaptée à la tête de retenue (14), de sorte que les surfaces sphériques tournées les unes vers les autres permettent un mouvement de compensation les unes par rapport aux autres à la façon d'un joint sphérique.

10. Unité de fixation selon l'une quelconque des revendications précédentes, **caractérisée en ce que** la tige de fixation (12) présente sur son extrémité (34) éloignée de la tête de retenue (14) un filetage (32) qui est associé à un filetage (32) dans un trou (40) dans le corps de refroidissement (42) ou corps (44).

11. Unité de fixation selon l'une quelconque des revendications précédentes, **caractérisée en ce que** la tige de fixation (12) présente sur son extrémité (34) éloignée de la tête de retenue (14) un filetage (32), qui est associé à un filetage (32) dans un trou (40) dans le corps de refroidissement (42) ou corps (44).

12. Unité de fixation selon l'une quelconque des revendications précédentes, **caractérisée en ce que** la tête de retenue (14) est constituée d'un matériau thermiquement et/ou électriquement isolant, ou d'un matériau électroconducteur.

13. Utilisation d'au moins deux unités de fixation selon l'une quelconque des revendications précédentes pour relier un corps de refroidissement (42) et un corps (44) l'un à l'autre, **caractérisée en ce que** deux unités de fixation (10) sont montées à l'opposé sur le bord du corps (44) ou corps de refroidissement (42), et forment un montage libre avec le corps (44) ou corps de refroidissement (42).

14. Utilisation selon la revendication 13, **caractérisée en ce que** dans l'état monté les rainures de retenue (24) des unités de fixation (10) sont orientées parallèlement les unes aux autres.
